# EUROPEAN PATENT APPLICATION

(11) **EP 4 718 486 A1**
(43) Date of publication of application: **01.04.2026**
(21) Application number: 24306580.2
(22) Date of filing: 27.09.2024
(51) Int. Cl.: H01G 4/33, H01G 4/08, H01G 4/12, H01G 4/005, H01G 4/012, H01G 4/38, H10D 1/68

(54) **ELECTRICAL DEVICE COMPRISING A CAPACITOR FOR HIGH VOLTAGE APPLICATIONS AND METHOD FOR MANUFACTURING THEREOF**

(71) Applicant: Murata Manufacturing Co., Ltd., Nagaokakyo-shi, Kyoto 617-8555 (JP)
(72) Inventor: GABORIEAU, Sophie, 14000 CAEN (FR); GREVIR, Régis, 14000 CAEN (FR); BOUDET, Grégoire, 14000 CAEN (FR); BOUVIER, Stéphane, 14000 CAEN (FR)
(74) Representative: Cabinet Beau de Loménie

(57) **Abstract**

The proposed electrical device (100) comprises a capacitor including:
- a bottom electrode (110),
- a dielectric structure (120) extending conformally on the bottom electrode (110) and comprising dielectric layers (121-123), wherein the dielectric structure (120) extends only within a central region of the bottom electrode (110),
- a top electrode (130) extending conformally on the dielectric structure (120),
- a passivation layer (160) extending on the bottom electrode (110) within a peripheral region of the bottom electrode (110), the peripheral region surrounding the dielectric structure (120) and extending up to lateral edges of the electrical device (100), and
wherein:
- the lateral edges of each of the dielectric layers (121-123) are covered at least by the passivation layer (160).

## Description

### Field of the invention

The present invention relates to the field of electrical devices. More particularly, it relates to an electrical device comprising a capacitor and a method for manufacturing thereof. The present invention is particularly advantageous for implementing capacitors for high voltage applications, but such an application is only given as an illustrative example and does not limit the invention.

### Description of Related Art

The present invention lies within the particular context of capacitors for high voltage applications (*e.g*., with operating voltages exceeding 600V), but is not limited to this particular context. For high-voltage applications, standard capacitor architectures use thick dielectric layers (*e.g*., silicon oxide layers) deposited on a semiconductor substrate (*e.g.,* a silicon substrate).

However, these standard capacitor architectures suffer from multiple drawbacks. Reliability tests conducted on these architectures under conditions of high temperature, voltage and humidity revealed certain reliability issues. Specifically, these tests have shown potential capacitor failure due to humidity penetrating the capacitor.

In order to prevent capacitor failure due to humidity, an existing solution consists in introducing a seal ring surrounding the capacitor area. However, the introduction of a seal ring reduces the effective capacitor area (*e.g*., at least by 70µm on each side), and thus the capacitance density. The seal ring also induces significant topography, which can lead to processing issues during the capacitor manufacture. Furthermore, the seal-ring can increase the sensitivity of the capacitor to electric discharge (*i.e.*, seal-ring to top electrode).

Moreover, standard capacitors are typically delimited by dicing through the various layers in the saw lanes. However, standard capacitor architectures are prone to silicon substrate chipping when dicing through the thick dielectric layers (*e.g*., including a layer of high tensile stress nitride) of the capacitor.

Therefore, there is a need for an electrical device comprising a capacitor with a high capacitance density, and capable of reliably withstanding high voltages and humidity.

### Summary of the Invention

The present invention has been made in the light of the above problems.

According to an aspect, the present invention provides an electrical device comprising a capacitor including:
- a bottom electrode comprising a conductive structure (*e.g*., the conductive structure comprises a substrate),
- a dielectric structure extending conformally on (and in contact with) the bottom electrode and comprising one or more dielectric layers (*e.g.*, oxide layers) having lateral edges, wherein the dielectric structure extends only within a central region of the bottom electrode,
- a top electrode extending conformally on the dielectric structure, the top electrode comprising at least one conductive layer (*e.g*., a polysilicon layer),
- a passivation layer extending on and in contact with the bottom electrode within a peripheral region of the bottom electrode, the peripheral region surrounding the dielectric structure and extending up to lateral edges of the electrical device (*i.e*., the die edges),
wherein:
- the lateral edges (*i.e*., vertical edges) of each of said one or more dielectric layers of the dielectric structure are covered at least by the passivation layer.

During the reliability tests carried out on standard capacitor architectures, the inventors have observed that the dielectric layers (*e.g*., oxide layers) used to form the capacitor dielectric are not completely hermetic. Humidity penetrates through these dielectric layers at the die edges (*i.e.*, at the lateral edges of the electrical device). This can lead to the capacitor failure.

In contrast, the present invention proposes encapsulating the layers of the capacitor dielectric using a passivation layer, the latter forming a hermetic barrier preventing humidity from penetrating in the electrical device.

More specifically, the layers of the dielectric structure do not extend within said peripheral region of the bottom electrode. The dielectric layers do not extend over the saw lanes and do not extend up to the lateral edges of the electrical device once diced. In contrast, the passivation layer extends directly onto the bottom electrode within said peripheral region surrounding the dielectric structure. The passivation layer thus extends over the saw lanes and extends up to the lateral edges of the electrical device once diced. The passivation layer also extends over (either directly in contact, or not) the lateral edges of the dielectric layers of the dielectric structure. It follows that the lateral edges of each of the dielectric layers are covered at least by the passivation layer (they may be covered by the passivation layer and additional layers). In other words, the passivation layer covers the periphery of the dielectric structure.

The passivation layer used in the proposed solution forms a hermetic barrier preventing humidity from penetrating through the layers of the dielectric structure at the lateral edges of the electrical device (*i.e*., the die edges). Improved capacitor reliability follows as result. This has been confirmed by reliability tests carried out by the inventors.

With the proposed solution, the use of a seal ring is no longer necessary to prevent capacitor failure due to humidity. In comparison with a seal ring, the proposed solution involves only a limited increase in the surface area of the electrical device, for instance, 20µm on each side (the increase in surface area corresponds to said peripheral region surrounding the dielectric structure). The proposed solution thereby provides a reliable, humidity-resistant capacitor with a high capacitance density.

It has also been observed that the proposed solution improves dicing quality. In the proposed electrical device, there are no thick dielectric layers extending over the saw lanes. The proposed solution thereby contributes to preventing chipping of the substrate used to form the bottom electrode when dicing the electrical device.

For these reasons, the proposed solution provides an electrical device comprising a capacitor with a high capacitance density, and capable of reliably withstanding high voltages and humidity.

In a particular embodiment, the passivation layer comprises silicon nitride (Si₃N₄).

In this embodiment, silicon nitride is used to form the passivation layer. This has several advantages. On the one hand, silicon nitride can be easily deposited using conventional semiconductor manufacturing techniques. On the other hand, silicon nitride offers high resistance to humidity. Thereby, the passivation layer in silicon nitride provides an efficient hermetic barrier preventing humidity from penetrating in the electrical device.

In a particular embodiment, a thickness of the passivation layer is comprised between 0.5µm and 1.5µm.

This embodiment proposes using a passivation layer with a thickness comprised between 0.5µm and 1.5µm. This particular thickness provides an efficient hermetic barrier against humidity.

In a particular embodiment, the passivation layer covers (*i.e*., extends on or above) lateral edges (*i.e*., vertical edges) of each of the other layers of the capacitor extending over (*i.e*., on or above) the bottom electrode.

According to this embodiment, the passivation layer encapsulates not only the dielectric layers of the dielectric structure, but also the other layers forming the capacitor (in particular the top electrode, as well as potential inter-metal dielectric layers, and metal layers used to form electrical contacts with the capacitor). In other words, the lateral edges of each of the layers forming the capacitor that are deposited above the bottom electrode are covered at least by the passivation layer (they can be covered by the passivation layer and also by additional layers). The passivation layer thus provides humidity protection for the entire capacitor. This embodiment contributes to improving the capacitor reliability.

In a particular embodiment, the electrical device further comprises an additional passivation layer extending on the passivation layer and covering the lateral edges of each of said one or more dielectric layers.

This embodiment proposes using an additional passivation layer. This layer extends over the passivation layer (e.g., comprising Si₃N₄) and covers the lateral edges of the dielectric layers. Thereby, the lateral edges of the dielectric layers of the dielectric structure are covered by the passivation layer and by the additional passivation layer (stacked on each other). In other words, there is a double barrier preventing humidity from penetrating in the capacitor through the dielectric layers. This double hermetic barrier contributes to improving the capacitor reliability.

In a particular embodiment, the additional passivation layer comprises polyimide, and/or a thickness of the additional passivation layer is comprised between 3.5µm and 10µm.

In this embodiment, the additional passivation layer is formed using polyimide. The polyimide layer extends over the passivation layer (*e.g*., comprising Si3N4) and covers the lateral edges of the capacitor dielectric layers. This polyimide layer extends everywhere (*i.e.*, over the entire surface of the wafer), except for the openings of the connection pads where wire bonding is performed. In particular, the polyimide layer extends over the saw lanes, as it allows avoiding arcing during wafer electrical test (as detailed below).

The thickness of the polyimide layer can be comprised between 3.5um and 10um (*e.g*., the thickness of this layer can be 9µm), but even greater thicknesses could also be used. This polyimide layer can be deposited using spin coating. Alternatively, the polyimide layer could also be deposited using lamination (foil); in this case, the thickness of the polyimide layer is greater and the resolution inferior (but this is not an issue for the proposed electrical device since the openings of the connection pads are relatively large).

This additional passivation layer of polyimide allows avoiding arcing between the bottom electrode at the saw-lane and the top electrode at the connection pad during electrical testing. This test is carried out at high voltage, and if the distance between the saw-lane and the connection pad is not sufficient, arcing may occur (such short distance between the saw-lane and the connection pad may result from assembly constraints: multiple large wires may have to be used for the top electrode, and therefore large connection pads may be required).

In a particular embodiment, the dielectric structure comprises a stack of layers including:
- a first dielectric layer comprising silicon oxide (SiO₂) (*e.g.*, thermally grown on the silicon substrate forming the bottom electrode),
- a second dielectric layer comprising silicon nitride (Si₃N₄), and
- a third dielectric layer comprising silicon oxide (SiO₂).

This embodiment proposes using a multi-layer dielectric structure comprising (thermally grown) silicon oxide, silicon nitride, and silicon oxide. This dielectric stack is particularly advantageous for high-voltage capacitors for the following reasons. First, the use of silicon nitride provides a dielectric structure with high dielectric strength. Second, the use of thermal silicon dioxide provides a dielectric structure with a strong adherence to the silicon substrate of the bottom electrode. Third, this stack can be easily formed using standard manufacturing techniques.

It should be noted that the present invention is not limited to this particular stack of dielectric layers to form the dielectric structure of the capacitor. Within the scope of the present invention, other embodiments could be envisaged in which other dielectric stacks are used, with additional or different dielectric layers.

In a particular embodiment, the electrical device comprises:
- a first inter-metal dielectric layer extending on the top electrode and comprising contact holes delimiting respectively an opening onto the top electrode, and
- a first metal layer extending on the first inter-metal dielectric layer and filling the contact holes to form electrical contacts with the top electrode.

This embodiment allows forming electrical contacts and/or interconnections with the capacitor (via the first metal layer).

For instance, this embodiment can be used to provide a monolithic resistor-capacitor component with a high integration density. Specifically, the capacitor is formed by the bottom electrode, the dielectric structure, and the top electrode. And, the resistance results from the intrinsic resistivity of the top electrode. There is hence no need for a separate resistor to be connected to the capacitor. The electrical contacts, formed by the metal layer filling the contact holes of the inter-metal dielectric layer, allow tuning the resistance value of the component with great flexibility, simply by adjusting the number and area of the contact holes.

The present invention is not limited to this particular embodiment. The proposed electrical device can be used for applications other than providing a resistor-capacitor component.

In a particular embodiment, the electrical device comprises:
- a second inter-metal dielectric layer extending on the first inter-metal dielectric layer and on the first metal layer, the second inter-metal dielectric layer defining an opening onto the first metal layer,
- a second metal layer extending on the second inter-metal dielectric layer and on the first metal layer through the opening in the second inter-metal dielectric layer, and wherein:
- a thickness of the stack of the first and second metal layers is equal to or greater than 6µm.

This embodiment proposes using a thick stack of two metal layers to form electrical contacts between the capacitor of the proposed electrical device and other components. This thick stack of metal layers allows performing wire-bonding with large diameter aluminum wires without damaging the capacitor.

The second inter-metal layer extends on the bottom electrode, covers the lateral edges of the dielectric layers of the dielectric structure, and extends on the first inter-metal dielectric layer and on the first metal layer.

In a particular embodiment, the conductive structure of the bottom electrode comprises reliefs, such as pores, holes, trenches, or pillars.

This embodiment proposes using a three-dimensional capacitor. That is, a capacitor whose capacitive structure is formed conformally on reliefs such as pores, holes, trenches, or pillars. The use of a three-dimensional capacitor allows providing a large specific area for a given component size. A high capacitance density follows as a result.

In a particular embodiment, the electrical device is configured to be used with an operating voltage measured between the bottom electrode and the top electrode exceeding 600V (or even exceeding 900V, or 1200V). For instance, the proposed electrical device may be used as a decoupling or snubber capacitive element for power electronic.

According to another aspect, the present invention provides a method for manufacturing an electrical device comprising a capacitor, said method comprising:
- providing a bottom electrode comprising a conductive structure,
- forming a dielectric structure extending conformally on the bottom electrode and comprising one or more dielectric layers having lateral edges, wherein the dielectric structure extends only within a central region of the bottom electrode (*i.e*., the dielectric structure does not extend over the saw lanes),
- forming a top electrode extending conformally on the dielectric structure and comprising at least one conductive layer,
- forming a passivation layer extending on and in contact with the bottom electrode within a peripheral region of the bottom electrode surrounding the dielectric structure (*i.e.,* the passivation layer extends over the saw lanes and also over, on or above, the dielectric structure), and
wherein:
- the lateral edges of each of said one or more dielectric layers of the dielectric structure are covered at least by the passivation layer.

The proposed manufacturing method can be adapted to obtain any one of the electrical devices defined in the present disclosure. Further, it should be noted that the embodiments of the proposed method for manufacturing an electrical device present the advantages described in relation with the embodiments of the proposed electrical device.

In a particular embodiment, the proposed method comprises:
- dicing to delimit the electrical device, wherein the dicing is performed in said peripheral region (*i.e*., the saw lanes region) surrounding the dielectric structure, and the dicing is performed (only) through the bottom electrode and the passivation layer (and eventually, the additional passivation layer).

With regards to this embodiment, it should be noted that only the bottom electrode and the passivation layer (and eventually, the additional passivation layer) extend in the saw lanes region and that no other layers are present in this region. In particular, there are no thick dielectric layers present in the saw lanes region. This prevents the silicon substrate used to form the bottom electrode from chipping when dicing the electrical device.

In a particular embodiment, the passivation layer comprises silicon nitride, and/or a thickness of the passivation layer is comprised between 0.5µm and 1.5µm.

In a particular embodiment, the passivation layer is formed (*i.e*., deposited) using plasma enhanced chemical vapor deposition.

### Brief Description of the Drawings

Further features and advantages of the present invention will become apparent from the following description of certain embodiments thereof, given by way of illustration only, not limitation, with reference to the accompanying drawings in which:
FIGS. 1A-1C illustrate an electrical device comprising a capacitor according to an embodiment outside the scope of the invention,
FIG. 2 illustrates an electrical device comprising a capacitor according to an embodiment of the invention, and
FIGS. 3A-3E illustrate steps of a method for manufacturing an electrical device comprising a capacitor according to an embodiment of the invention.

### Detailed Description of Example Embodiments

Embodiments of the present invention provide an electrical device with a high energy storage density and suited to high voltage applications. More specifically, embodiments of the present invention seek to improve reliability of such electrical device, in particular against humidity.

The present invention applies in particular to electrical devices using 3D capacitive structures formed using trenches. The following description of the invention will refer to this particular application, which is only given as an illustrative example. The present invention also applies to 3D capacitive structures based on other reliefs, and 2D capacitive structures.

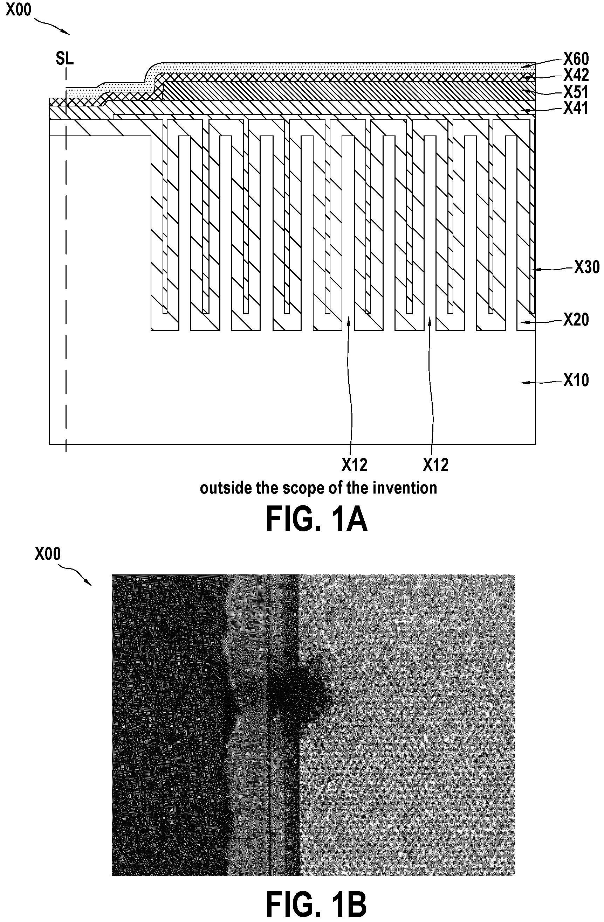

**FIGS. 1A-1C** illustrate an electrical device comprising a capacitor according to an embodiment outside the scope of the invention.

More specifically, FIG. 1A shows a side cross-section view of an electrical device X00. The latter comprises a capacitor formed by a bottom electrode X10 and a top electrode X30 separated by a dielectric structure X20.

The bottom electrode X10 comprises a conductive structure with reliefs (*e.g.*, trenches). Here, the reliefs of the conductive structure are formed by walls extending upwards from a base surface of the conductive structure. The conductive structure can be formed by etching a semiconductor substrate (*e.g*., a doped silicon substrate). The conductive structure could also be formed by a 3D substrate covered by a conductive layer.

The dielectric structure X20 extends conformally over the bottom electrode X10. It extends up to the saw lanes SL, and hence up to the lateral edges of the electrical device X00 (once diced).

The dielectric structure X20 can comprise a stack of multiple dielectric layers X21-X23 (stacked on each other in the bottom electrode X10 to top electrode X30 direction). In particular, the dielectric structure X20 can comprise silicon oxide SiO₂ thermally grown on a silicon substrate forming the bottom electrode X10. For high-voltage applications, a dielectric structure X20 with an important thickness (*e.g*., at least a few µm) is used to withstand high-voltages.

The top electrode X30 comprises a conductive layer extending conformally over the dielectric structure X20. For instance, the conductive layer of the top electrode can be a polysilicon layer.

As illustrated on FIG. 1A, the top electrode structure X30 fills the above-mentioned reliefs (*e.g*., trenches) formed by the bottom electrode X10 and the dielectric structure X20. That is, the top surface of the top electrode X30 lies above the top surface of the dielectric structure X20.

The electrical device X00 further comprises an inter-metal dielectric layer X41, a metal layer X51, an insulating layer X42, and a passivation layer X60.

The inter-metal dielectric layer X41 extends on the top electrode X10 and comprises contact holes (not represented on this figure) delimiting openings onto the top electrode X10.

The inter-metal dielectric layer X41 also extends on the dielectric structure X20. It extends up to the saw lanes SL, and hence up to the lateral edges of the electrical device X00 (once diced). The inter-metal dielectric layer X41 can be formed by depositing silicon oxide (SiO₂) using LPCVD (Low Pressure Chemical Vapor Deposition).

The metal layer X51 extends on the inter-metal dielectric layer X41 and fills the contact holes in the inter-metal dielectric layer X41. This allows forming electrical contacts with the top electrode X30 and hence with the capacitor.

The insulating layer X42 extends over the inter-metal dielectric layer X41 and on the metal layer X51. This layer X42 extends up to the saw lanes SL, and hence up to the lateral edges of the electrical device X00 (once diced).

The passivation layer X60 is deposited on the other layers and extends on the insulating layer X42. It extends up to the saw lanes SL and up to the lateral edges of the electrical device X00 (once diced). This passivation layer X60 can be made of a material providing mechanical protection, a moisture diffusion barrier and exhibiting good electrical insulating properties, for example, silicon nitride Si₃N₄.

With regards to the architecture of FIG. 1A, it is important to note that the dielectric layers X20 and X41 (*e.g*., comprising silicon oxide layers) extends up to the saw lanes SL. It follows, that once the electrical device X00 is diced, these dielectric layers extend up to the lateral edges of the electrical device X00 (*i.e.,* the die edges).

The reliability tests conducted by the inventors have shown that, with such architecture, humidity can penetrate through the oxide layers at the die edges. This can lead to the capacitor failure. FIG. 1B shows a capacitor in which humidity penetrated at the die edge during the humidity test.

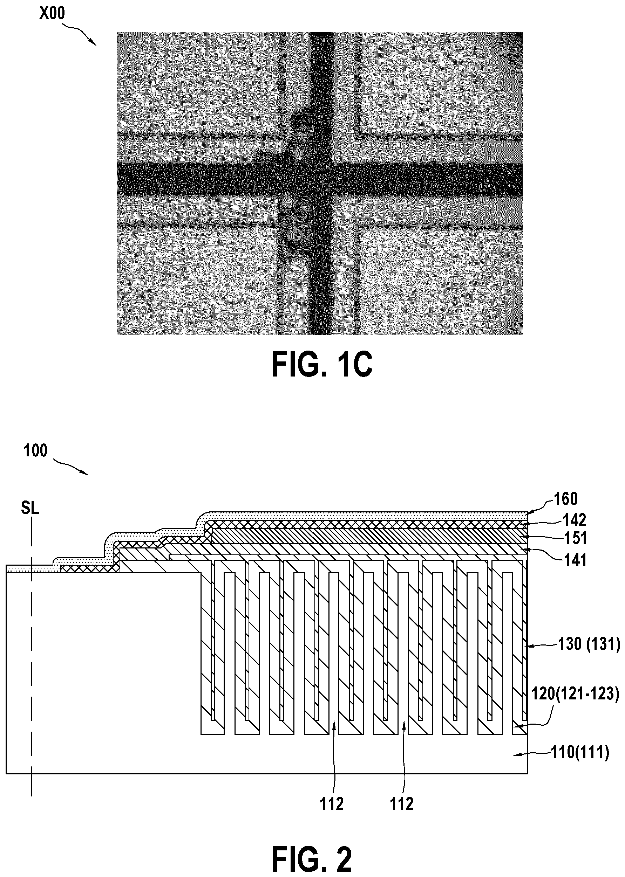

Moreover, the inventors have observed that the electrical device of FIG. 1A is also prone to chipping of the substrate X10 during dicing. This is due, in particular, to the presence of thick dielectric layers in the saw lanes SL. FIG. 1C illustrates chipping of the silicon substrate due to dicing.

These observations support the present invention and have led the inventors to propose the solution described below.

**FIG. 2** illustrates an electrical device comprising a capacitor according to an embodiment of the invention.

Compared to the electrical device X00 (presented above and outside the scope of the present invention), the proposed electrical device 100 differs in that the dielectric layers are encapsulated by the passivation layer 160.

As illustrated on FIG. 2, the lateral edges (vertical edges) of each layer 121-123 of the dielectric structure 120 are covered at least by the passivation layer 160. In the proposed solution, the passivation layer 160 is used to form a hermetic barrier preventing humidity from penetrating through the layers 121-123 of the dielectric structure 120 at the lateral edges of the electrical device 100 (*i.e.,* die edges).

The encapsulation of the dielectric structure 120 by the passivation layer 160 is now to be described more specifically in reference to the embodiment of FIG. 2.

The dielectric layers 121-123 extends on the bottom electrode 110, but they do not extend over the saw lanes SL. In other words, the dielectric structure 120 extends only within a central region of the bottom electrode 110, and does not extend within a peripheral region of the bottom electrode 110 surrounding the dielectric structure 120 (the central region and the peripheral region of the bottom electrode are disjoint).

And, the passivation layer 160 extends directly onto the bottom electrode 110 over the saw lanes SL. It extends on the bottom electrode 110 within the peripheral region surrounding the dielectric structure 120. In addition, the passivation layer 160 extends over (on or above) the dielectric structure 120 within the central region. It covers (either directly in contact, or not) the lateral edges of the dielectric layers 121-123. The passivation layer 160 covers the periphery of the dielectric structure 120.

Once the electrical device 100 is diced, the dielectric layers 121-123 do not extend up to the lateral edges of the electrical device 100 (*i.e.,* the die edges). Only the passivation layer 160 extends up to the lateral edges of the electrical device 100.

The passivation layer 160 forms a hermetic barrier preventing humidity from penetrating through the layers 121-123 of the dielectric structure 120 at the lateral edges of the electrical device 100. The reliability tests conducted by the inventors have confirmed that the proposed encapsulation allows improving the capacitor resistance to humidity, and thus the capacitor reliability.

The proposed solution also improves dicing quality. In the proposed electrical device 100, there are no thick dielectric layers extending over the saw lanes SL. This contributes to preventing chipping of the (silicon) substrate 111 when dicing the electrical device 100.

We have described here the encapsulation of the dielectric structure 120 by the passivation layer 160. Furthermore, one can note on FIG. 2 that the passivation layer 160 also encapsulates the other layers of the electrical device 100. This is described in more detail below in reference to the embodiment of FIG. 2.

The encapsulation of all layers by the passivation layer 160 is now presented.

As shown in FIG. 2, multiple layers are deposited and extend over the bottom electrode 110, namely the dielectric structure 120, the top electrode 130, the first inter-metal dielectric layer 141, the metal layer 151, and the second inter-metal dielectric layer 142.

It is important to note that these layers are all deposited so as not to extend up to the saw lanes SL. In other words, these layers extend only over (on or above) the bottom electrode 110 within the central region, and do no extend over the peripheral region surrounding the dielectric structure 120.

Then, the passivation layer 160 is deposited above the other layers and extends up to the saw lanes SL. The passivation layer 160 extends directly on the bottom electrode 110 within the peripheral region, and also extends over (on or above) the other layers forming the capacitor within the central region.

The passivation layer 160 thereby encapsulates, in this embodiment, all the capacitor layers deposited on the bottom electrode 110. The lateral edges (*i.e*., the vertical edges) of each of the capacitor layers deposited on the bottom electrode 110 are covered by the passivation layer 160.

In this embodiment, the passivation layer 160 protects not only the edges of the dielectric layers, but also the edges of the other layers forming the capacitor. The passivation layer 160 thus provides humidity protection for the entire capacitor of the electrical device 100. This contributes to improving the capacitor reliability.

We have described above the principle of the proposed solution and, in particular, the encapsulation of the dielectric structure 120 by the passivation layer 160 to prevent humidity from penetrating the electrical device 100. We will now detail the manufacture of this electrical device 100, in particular by specifying the materials and thicknesses used for the different layers thereof.

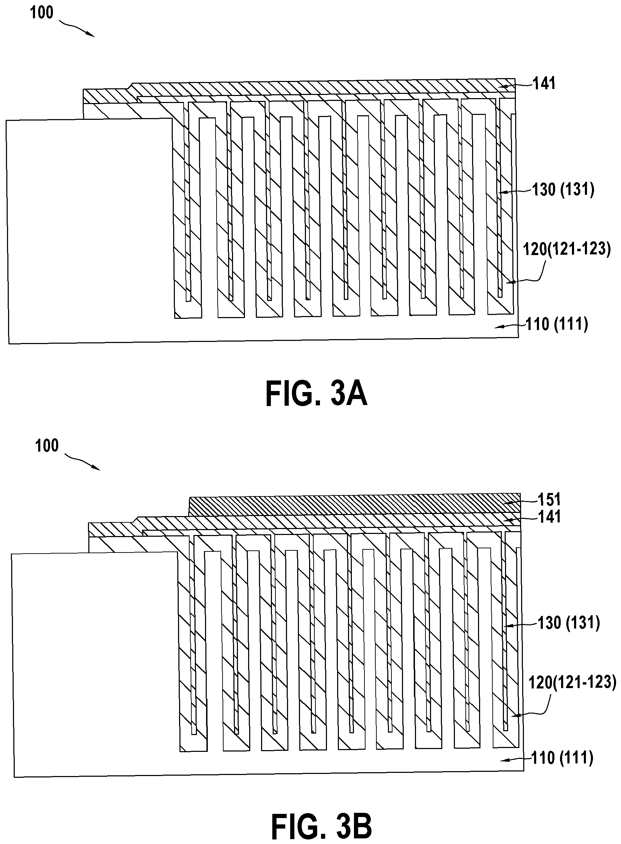

**FIGS. 3A-3E** illustrate steps of a method for manufacturing an electrical device comprising a capacitor according to an embodiment of the invention.

Prior to the manufacturing steps illustrated in these figures, the capacitor of the electrical device 100 is provided. That is, the capacitor of the electrical device 100 is formed by providing the bottom electrode 110, the dielectric structure 120, and the top electrode 130.

For instance, the bottom electrode 110 can be formed by etching trenches in a doped silicon substrate 111. The trenches in the silicon substrate 111 can be formed (as illustrated) by facing protruding walls 112. It follows that the capacitive structure is formed conformally on the trenches of the substrate 111. The use of such a three-dimensional capacitor allows providing a large specific area for a given component size. A high capacitance density follows as a result.

The dielectric structure 120 can comprise a stack of: a silicon oxide layer 121 formed by thermal oxidation of the silicon substrate 111, and a silicon nitride layer 122 formed using LPCVD, and a silicon oxide layer 123 formed using chemical vapor deposition of tetraethylorthosilicate. The thickness of the dielectric structure 120 can, for instance, be set to 2.5µm.

And, the top electrode 130 can be formed by depositing a polysilicon layer 131 so as to fill the trenches in the silicon substrate 111.

In FIG. 3A, a step is shown in which a first inter-metal dielectric 141 is deposited.

The first inter-metal dielectric layer 141 extends on the top electrode 130 and comprises contact holes (not represented in this figure) delimiting openings onto the top electrode 130.

The thickness of the first inter-metal dielectric 141 can be set to 2µm. The use of such a thick inter-metal dielectric layer allows reducing the parasitic capacitance (between the polysilicon layer 131 and the first metal layer 151) and contributes to improving the frequency behavior of the capacitor of the electrical device 100.

In FIG. 3B, a step is shown in which a first metal layer 151 is deposited.

The first metal layer 151 extends on the first inter-metal dielectric layer 141 and fills the contact holes to form electrical contacts with the top electrode 130. This allows forming electrical contacts with the capacitor.

For example, the first metal layer 151 can be a layer of aluminum (Al) or copper (Cu). The thickness of this layer can be comprised between 1µm to 3µm. The use of a first metal layer 151 with a thickness of 3µm allows better capability for further assembly with wire-bonding.

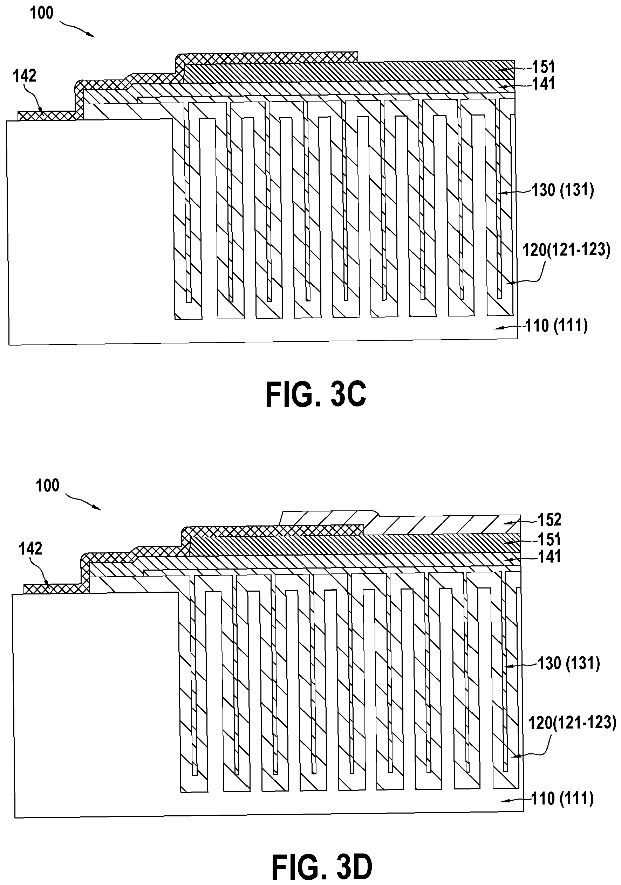

In FIG. 3C, a step is shown in which a second inter-metal dielectric layer 142 is deposited.

The inter-metal dielectric layer 142 comprises, for instance, silicon oxide (SiO₂). The thickness of this layer can be set to 1.5µm.

Here, the inter-metal dielectric layer 142 extends on (and in contact with) the bottom electrode 110, but not up to the saw lanes. It also extends on the dielectric structure 120 and the first inter-metal dielectric layer 141. The second inter-metal dielectric layer 142 thereby covers the lateral edges of the dielectric layers 121-123 and the first inter-metal dielectric layer 141.

The function of the inter-metal dielectric layer 142 is to define an opening on the first metal layer 151. In addition, the thickness of this layer 142 (*e.g.,* 1.5µm) is set in order to increase the resistance of the device to mechanical stress and also to withstand high voltages (several hundred volts can be measured between the first metal layer 151 and the second metal layer 152 when the electrical device 100 is used as a snubber for power electronics).

In FIG. 3D, a step is shown in which a second metal layer 152 is deposited.

The thickness of the second metal layer 152 can, for instance, be set to 3µm. It follows that the stack of the first and second metal layers 151-152 has a thickness of 6µm. This thick stack of metal layers above the top electrode 130 allows performing wire-bonding with large diameter aluminum wires without damaging the capacitor.

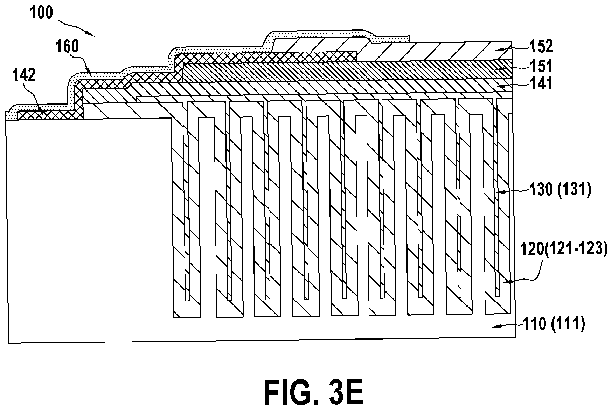

In FIG. 3E, a step is shown in which the passivation dielectric layer 160 is deposited.

For example, the thickness of this layer can be comprised between 0.5µm and 1.5µm. Such a thickness provides an efficient barrier to humidity.

Silicon nitride (Si₃N₄) can be used to form the passivation layer 160. Silicon nitride can be easily deposited using conventional semiconductor manufacturing techniques. The passivation layer 160 can, for instance, be deposited using PECVD (Plasma Enhanced Chemical Vapor Deposition). Moreover, silicon nitride presents a high resistance to humidity, and thereby provides efficient protection for the capacitor.

The present invention is not limited to this example embodiment. Other embodiments could be envisaged in which other thicknesses or materials could be used to form the passivation layer 160.

In an embodiment (not illustrated on the figures), the electrical device 100 comprises an additional passivation layer comprising polyimide. This layer extends over the passivation layer 160 and covers the lateral edges of the dielectric layers 121-123. This embodiment allows forming a double barrier preventing humidity from penetrating in the capacitor through the dielectric layers and thus contributes to improving the capacitor reliability.

More specifically, the additional passivation layer made of polyimide extends over the entire surface of the wafer (before the dicing of the electrical device), except for the openings of the connection pads where wire-bonding is performed. It extends in particular over the saw lanes, as this layer allows avoiding arcing during wafer electrical test (as previously discussed). The thickness of the polyimide layer can be comprised between 3.5µm and 10µm (*e.g*., this thickness can be 9µm), but greater thicknesses could be used. This polyimide layer can be deposited using spin coating or lamination (foil).

With regard to the manufacture of the proposed electrical device 100, it is important to note that the various dielectric and metal layers forming the electrical device 100 create topography (*i.e*., a difference in height between the level of the highest layer and the top of the bottom electrode) in the order of 12µm. For this reason, a thick photoresist is used to cover this topography and enable efficient patterning of the various dielectric and metal layers forming the electrical device 100. Lithographic exposure and development steps are adapted to avoid residues in the saw lanes.

After depositing the passivation layer 160, dicing is performed to delimit the electrical device 100. The dicing is performed through the saw lanes (*i.e*., in the region surrounding the dielectric structure 120). The dicing is performed only through the bottom electrode 110 and the passivation layer 160 (and eventually the additional passivation layer). This prevents chipping of the substrate 111 (there are no thick dielectric layers extending over the saw lanes).

Then, the proposed electrical device 100 can be used with an operating voltage measured between the bottom electrode and the top electrode exceeding 600V (or even exceeding 900V, or 1200V). The electrical device 100 can be used for high temperature applications (*e.g.*, exceeding 175 °C). For instance, the proposed electrical device may be used as a decoupling or snubber capacitive element for power electronic.

Thereby, the proposed solution provides an electrical device 100 comprising a capacitor with a high capacitance density, and capable of reliably withstanding high voltages and humidity.

**Additional Variants:** Although the present invention has been described above with reference to certain specific embodiments, it will be understood that the invention is not limited by the particularities of these specific embodiments. Numerous variations, modifications, and developments may be made in the above-described embodiments within the scope of the claims.

In particular, the present invention has been described in reference to a 3D capacitive structure formed using trenches. However, other embodiments of the present invention could be envisaged. The present invention also applies to 3D capacitive structures based on other reliefs (*e.g*., pores, holes, pillars), and 2D capacitive structures.

It is to be understood that references in this text to directions and locations, such as "top" and "bottom", "front" and "rear", merely refer to the directions that apply when architectures and components are oriented as illustrated in the accompanying drawings.

## Claims

1. An electrical device (100) comprising a capacitor including:
- a bottom electrode (110) comprising a conductive structure,
- a dielectric structure (120) extending conformally on the bottom electrode (110) and comprising one or more dielectric layers (121-123) having lateral edges, wherein the dielectric structure (120) extends only within a central region of the bottom electrode (110),
- a top electrode (130) extending conformally on the dielectric structure (120) and comprising at least one conductive layer (131),
- a passivation layer (160) extending on and in contact with the bottom electrode (110) within a peripheral region of the bottom electrode (110), the peripheral region surrounding the dielectric structure (120) and extending up to lateral edges of the electrical device (100), and
wherein:
- the lateral edges of each of said one or more dielectric layers (121-123) of the dielectric structure (120) are covered at least by the passivation layer (160).

2. The electrical device (100) according to claim 1, wherein the passivation layer (160) comprises silicon nitride.

3. The electrical device (100) according to claim 1 or 2, wherein a thickness of the passivation layer (160) is comprised between 0.5µm and 1.5µm.

4. The electrical device (100) according to any of claims 1 to 3, wherein the passivation layer (160) covers lateral edges of each of the other layers of the capacitor extending over the bottom electrode (110).

5. The electrical device (100) according to any of claims 1 to 4, further comprising an additional passivation layer extending on the passivation layer (160) and covering the lateral edges of each of said one or more dielectric layers (121-123).

6. The electrical device (100) according to claim 5, wherein the additional passivation layer comprises polyimide, and/or a thickness of the additional passivation layer is comprised between 3.5µm and 10µm.

7. The electrical device (100) according to any of claims 1 to 6, wherein the dielectric structure (120) comprises a stack of dielectric layers including:
- a first dielectric layer (121) comprising silicon oxide,
- a second dielectric layer (122) comprising silicon nitride, and
- a third dielectric layer (123) comprising silicon oxide.

8. The electrical device (100) according to any of claims 1 to 7, further comprising:
- a first inter-metal dielectric layer (141) extending on the top electrode (130) and comprising contact holes delimiting openings onto the top electrode (130), and
- a first metal layer (151) extending on the first inter-metal dielectric layer (141) and filling the contact holes to form electrical contacts with the top electrode (130).

9. The electrical device (100) according to claim 8, comprising:
- a second inter-metal dielectric layer (142) extending on the first inter-metal dielectric layer (141) and on the first metal layer (151), the second inter-metal dielectric layer (152) defining an opening onto the first metal layer (151),
- a second metal layer (152) extending on the second inter-metal dielectric layer (141) and on the first metal layer (151) through the opening in the second inter-metal dielectric layer (142), and
wherein:
- a thickness of the stack of the first and second metal layers (151-152) is equal to or greater than 6µm.

10. The electrical device (100) according to any of claims 1 to 9, wherein the conductive structure of the bottom electrode (110) comprises reliefs, such as pores, holes, trenches, or pillars.

11. The electrical device (100) according to any of claims 1 to 10, wherein the electrical device (100) is configured to be used with an operating voltage measured between the bottom electrode (110) and the top electrode (130) exceeding 600 V.

12. A method for manufacturing an electrical device (100) comprising a capacitor, said method including:
- providing a bottom electrode (110) comprising a conductive structure,
- forming a dielectric structure (120) extending conformally on the bottom electrode (110) and comprising one or more dielectric layers (121-123) having lateral edges, wherein the dielectric structure (120) extends only within a central region of the bottom electrode (110),
- forming a top electrode (130) extending conformally on the dielectric structure (120) and comprising at least one conductive layer (131),
- forming a passivation layer (160) extending on and in contact with the bottom electrode (110) within a peripheral region of the bottom electrode (110) surrounding the dielectric structure (120), and
wherein:
- the lateral edges of each of said one or more dielectric layers (121-123) of the dielectric structure (120) are covered at least by the passivation layer (160).

13. The method according to claim 12, comprising:
- dicing to delimit the electrical device (100), wherein the dicing is performed in said peripheral region surrounding the dielectric structure (120) and is performed through the bottom electrode (110) and the passivation layer (160).

14. The method according to claim 12 or 13, wherein the passivation layer (160) comprises silicon nitride, and/or a thickness of the passivation layer (160) is comprised between 0.5µm and 1.5µm.

15. The method according to any of claims 12 to 14, wherein the passivation layer (160) is formed using plasma enhanced chemical vapor deposition.
